# EUROPEAN PATENT APPLICATION

(11) **EP 0 708 582 A1**
(43) Date of publication of application: **24.04.1996**
(21) Application number: 95114838.6
(22) Date of filing: 21.09.1995
(51) Int. Cl.: H05K 3/32, H01L 21/60

(54) **Electrically conductive paste materials and applications**

(30) Priority: 20.10.1994 US 326626
(71) Applicant: International Business Machines Corporation, Armonk, N.Y. 10504 (US)
(72) Inventor: Kang, Sung K., Chappaqua, New York 10514 (US); Graham, Teresita O., Irvington, New York 10533 (US); Purushothaman, Sampath, Yorktown Heights, New York 10598 (US); Roldan, Judith Marie, Ossining, New York 10562 (US); Saraf, Ravi F., Briarcliff Manor, New York 10510 (US)
(74) Representative: Rach, Werner, Dr.

(57) **Abstract**

A structure and method of fabrication are described. The structure is a combination of a polymeric material (36) and particles (32), e.g. Cu, having an electrically conductive coating (34), e.g. Sn. Heat is applied to fuse the coating of adjacent particles. The polymeric material (36) is a thermoplastic. The structure is disposed between two electrically conductive surfaces (40,42), e.g. chip and substrate pads, to provide electrical interconnection and adhesion between their pads.

## Description

### FIELD OF THE INVENTION

The present invention relates to novel interconnection materials for forming electroconductive connections between electroconductive members, and to the method for producing such electroconductive connections. In addition, this invention addresses environmentally-safe materials and processes, which can be an alternative to lead (Pb)-containing solder connection technology.

### BACKGROUND

Most electrical conductors used in electronic devices are made of metals, such as copper, aluminum, gold, silver, lead/tin (solder), molybdenum and others. Solder connection technology using lead/tin alloys plays a key role in various levels of electronic packaging, such as flip-chip connection (or C4), solder-ball connection in ball-grid-arrays (BGA), IC package assembly to a printed circuit board (PCB). Solder joints produced in the electronic packages serve critically as electrical interconnections as well as mechanical/physical connections. When either of these functions fails, the solder joint is considered to have failed, which can often threaten a shut-down of the whole electronic system.

Flip-chip connection is a most effective chip interconnection method currently used for high performance packaging applications, such as multichip modules, where lead (Pb)-rich solder bumps connect high performance chips directly to a ceramic substrate.

Solder-ball connection in ball-grid array (BGA) packages is an extension of the flip-chip connection method, where either single-chip or multichip modules are connected to a polymeric PCB by using a grid array of large solder balls. The solder balls currently in use have the composition of a high tin content, such as Pb-10%Sn or Pb-20%Sn, in order to act as a non-melting stand-off when these modules are attached to the PCB substrate using lower melting point Pb-Sn eutechic solder.

When microelectronic packages are assembled to a printed circuit board, the lead-tin eutectic solder, 63%Sn-37%Pb, having the lowest melting point (183°C) among Pb-Sn alloys, is most widely used. In these applications, there are two solder connection technologies employed for mass production: plated-through-hole (PTH) and surface mount technology (SMT) soldering. The basic difference between the two technologies originates from the difference in the PCB design and its interconnection scheme.

In PTH soldering, solder joints are made by utilizing the plated-through-holes on a PCB. For example, in wave soldering, molten solder is directly applied to the area of the PTH and is further drawn in by a capillary force to fill the gap between the I/O pin and the wall of the plated-through hole.

In SMT soldering, microelectronic packages are directly attached to the surface of a PCB. A major advantage of SMT is high packaging density, which is realized by eliminating most PTH's in the PCB as well as by utilizing both surfaces of the PCB to accommodate components. In addition, SMT packages have a finer lead pitch and a smaller package size compared to traditional PTH packages. Hence, SMT has contributed significantly in reducing the size of electronic packages and thereby the volume of the overall system.

In SMT soldering, solder paste is applied to a PCB by screen printing. Solder paste consists of fine solder powder, flux, and organic vehicles. During the reflow process, solder particles are melted, flux is activated, solvent materials are evaporated, and simultaneously molten solder coalesces and is eventually solidified. In contrast, in the wave soldering process, a PCB is first fluxed and components are mounted on it. Then it is moved over a wave of molten solder. The soldering process is usually completed by subjecting the solder joints to a cleaning step to remove residual flux materials. Due to environmental concerns, CFCs and other harmful cleaning agents are being eliminated and replaced by either water-soluble or no-clean flux materials.

Recent advances in microelectronic devices demand a very fine pitch connection between electronic packages and a printed circuit board on the order of a few hundred micrometer pitch). The current solder paste technology used in SMT can not handle this very fine pitch interconnection due to the soldering defects such as bridging or solder bailing. Another technical limitation of using the Pb-Sn eutectic solder is its high reflow temperature, approximately 215°C. This temperature is already higher than the glass transition temperature of the epoxy resin used in most polymeric printed circuit board materials. Thermal exposure at this reflow temperature produces significant thermal strains in a printed circuit board after soldering, especially in the direction perpendicular to the surface of a PCB, where no structural reinforcement is present. Thereby, the residual thermal strains in an assembled PCB would adversely affect the reliability of an electronic system.

A more serious concern regarding the usage of lead (Pb)-containing solders is an environmental issue, which we have experienced already in other industries by eliminating lead from gasoline, paints, and household plumbing solders.

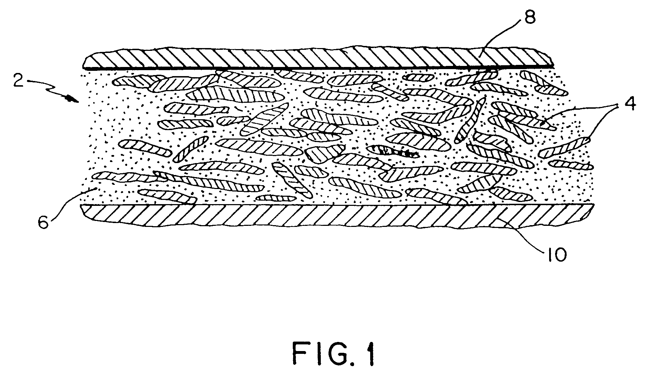

In the electronic industry, two different groups of materials are being investigated currently for the possibility of replacing the Pb-containing solder materials; Pb-free solder alloys, and electrically conductive pastes (ECP). The present invention discusses the development and applications of the electrically conductive paste materials. An electrically conductive paste (or adhesive) is made of electrically conducting filler particles loaded in the matrix of a polymer material. Silver-particle filled epoxy 2 is the most common example of the electrically conductive pastes, schematically shown in FIG. 1. The silver particles 4, usually in the shape of flakes, provide electrical conduction by percolation mechanism, while the epoxy matrix 6 provides adhesive bond between the components 8 and a substrate 10. This silver-filled epoxy material has been long used in the electronic applications as a die-bonding material, where its good thermal conduction rather than electrical conduction property is utilized. However, this material has not been accepted for the applications requiring high electroconduction and fine pitch connection. The silver-filled epoxy material has several limitations, such as low electrical conductivity, increase in contact resistance during thermal exposure, low joint strength, silver migration, difficulty in rework, and others. Since this silver-filled epoxy material is electrically conductive in all the directions, it is classified as "isotropic" in electro-conduction.

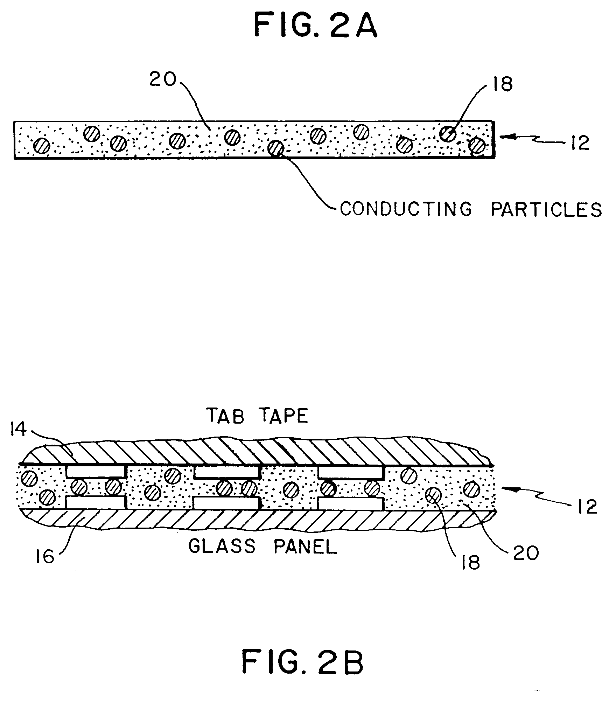

There is another class of electrically conductive adhesive (or film), which provides electroconduction only in one direction. This class of the materials is called as "anisotropic" conductive adhesive or film 12, shown schematically in FIG. 2, contains electrically conductive particles 18 within a polymeric adhesive material 20. The anisotropic conductive adhesive or film 12, becomes conductive only when it is compressed between two conducting pads 14 and 16 as shown in FIG. 2B. This process normally requires heat and pressure. The major application of the anisotropic conductive film is for joining of a liquid crystal display panel to its electronic printed circuit board. The conducting particles are usually deformable, such as solder balls, or plastic balls coated with nickel and gold. The binder or adhesive material is mostly a thermosetting resin.

### OBJECTS

It is an object of the present invention to provide an electrically conductive paste material which is environmentally safe and low cost.

It is an object of the present invention to provide an electrically conductive paste material which produces a higher electrical conductivity than the conventional silver-filled epoxy does.

It is another object of the present invention to provide an electrically conductive paste material which produces a higher joint strength than the conventional silver-filled epoxy does.

It is another object of the present invention to provide an electrically conductive paste material which produces a more reliable joint than the conventional silver-filled epoxy does, specifically, in terms of silver migration under an application of temperature/humidity/voltage.

### SUMMARY

A broad aspect of the present invention is an electrically conductive material formed from a plurality of particles, each having an electrically conductive coating which is fused to an electrically conductive coating on an adjacent particle to form a network of fused particles.

Another broad aspect of the present invention is a paste containing particles having a coating of an electrically conductive material and a polymer material.

Another broad aspect of the present invention is a method of forming an electrically conductive joint between two surfaces by forming a paste of particles having an electrically conductive coating and a polymeric material wherein the paste is disposed between two surfaces to be adhesively and electrically joined. Heat is provided to fuse the electrically conductive particles to themselves, to metallurgically bond them to the contact pads and to cure the polymeric material.

### BRIEF DESCRIPTION OF THE DRAWINGS

Further objects, features and advantages of the present invention will become apparent from a consideration of the following detailed description of the invention when read in conjunction with the drawing Figures 1-7 in which:
FIG. 1 is a schematic illustration of an electrically conductive paste comprising silver flake particles as a filler in the matrix of epoxy resin. The conductive paste is classified as isotropic in electroconduction. (prior art)
FIG. 2A is a schematic illustration of an electrically conductive adhesive which becomes electrically conductive only in the one direction when the adhesive film is compressed between two contact or bond pads as shown in FIG. 2B. The conductive adhesive (or film) is classified as anisotropic. (prior art)
FIG. 3 is a schematic drawing of a paste according to the present invention. FIG. 4 is a schematic illustration of an electrically conductive paste material according to the present invention, comprising particles filled in the matrix of thermoplastic polymer resin. The particles are coated with low melting point, non-toxic metals which were fused to achieve metallurgical bonding between adjacent particles, and between the particles and the contact surfaces that are joined using the paste.
FIG. 5 is a schematic cross-sectional illustration representing a surface mount integrated circuit package connected to a circuit board by an electrically conductive paste according to the invention.
FIG. 6 is a schematic cross-sectional illustration representing an integrated circuit chip directly attached to a high density printed circuit board by using the electrically conductive paste according to the present invention.
FIG. 7 is a schematic illustration of a multilayer ceramic substrate with the conductive paste structure matching to the C4 bump structure on a silicon wafer. The multilayer ceramic substrate serves as a vehicle for wafer-scale burn-in and chip testing.

### DETAILED DESCRIPTION

In one particular embodiment, we disclose a new electrically conductive paste material consisting of tin-coated copper powder, polyimide-siloxane, solvent (N-methyl pyrrolidione or NMP), carboxylic acid/surfactant. A joining operation can be performed near the melting point of Sn, 230°C, where a metallurgical bonding of Sn-to-Sn or Sn-to-Au is accomplished at the particle-to-particle as well as particle-to-substrate pad interfaces. The joining process can be either solid-state or liquid-solid reaction. The polymer curing process can be combined with the joining process depending on the paste formulation. Because of the metallurgical bonding, a higher electrical conductivity is expected with the joints made of the new paste material than with those of the silver-epoxy material. The metallurgical bonds also provide stable electrical conductivity of the new joints upon thermal exposure and cycling. It is also expected to have a higher joint strength from the combined effect of the metallurgical and adhesive bonds. Depending on the applications, the particle size of tin-coated powder, composition of the polymer matrix and volume fraction of the filler material can be adjusted. Since the present conductive paste is primarily based on the metallurgical bonds, the critical volume fraction of the filler material required to achieve acceptable conductivity levels is much less than the conventional Ag-epoxy paste.

In another embodiment, we propose the use of polymer resins prepared from renewable resources or bio-based materials after appropriate functionalization to achieve the desirable thermal and rheological properties, see for example, the final report on NSF Grant # BCS 85-12636 by W.G. Glasser and T.C. Ward. Lignin (by product from paper manufacture), cellulose, wood or crop oils are potential candidates for this purpose. Use of these materials is environmentally preferable because they are derived from natural and renewable resources and can be disposed of more readily at the end of the useful life of the electronic assembly. This is particularly attractive because the use of the Cu-Sn powder eliminates the use of lead (Pb) containing solders and the resulting paste formulation is non-toxic and easy to dispose.

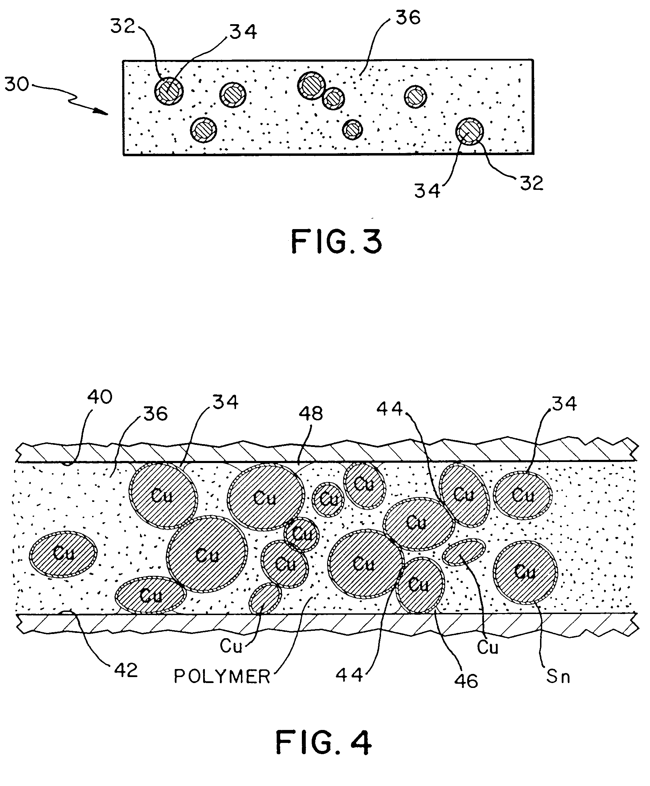

FIG. 3 illustrates new electrically conductive paste (ECP) materials 30, according to the present invention, comprising particles 32 having an electrically conducting coating 34, as conducting filler materials, and a polymer matrix 36. The particles 32 are preferably Cu particles. The coating 34 is preferably tin, indium, and bismuth antimony or combinations thereof. The polymer matrix is preferably a thermoplastic, most preferably a polyimide siloxane. The invention will be described below in terms of the preferred embodiment, but it is not limited thereto.

The first step of tin-plating on copper powder is cleaning of fine copper powder in a dilute sulfuric acid. The copper powder used is spherical in shape, having a size distribution of 2 to 8µm in diameter, which was obtained from Degussa Corporation, South Plainfield, NJ. Tin plating is performed on the clean copper powder in an immersion tin plating solution, TINPOSIT LT-34, from Shipley, Newton, MA. The optimum thickness of tin is 0.3 to 0.5 µm on 5-7 µm Cu powder. After rinsing, the tin-plated copper powder is immediately mixed with a no-clean flux, FLUX305, from Qualitek International, Inc., Addison, IL. This prevents tin-plated copper powder from oxidation until it is processed into a conductive paste. The tin-plated copper powder is formulated into a conducting paste by mixing with polyimide siloxane, NMP solvent, butyric acid and ethylene glycol. The relative amount of filler powder over the polymer matrix is varied from 30 to 90 % in weight, depending on the applications. In general, for the isotropic conduction, a high filler weight percent is required, while a low filler weight percent is required for the anisotropic applications. To insure uniform dispersion of the ingredients, the mixture is processed in a three-roll shear mill. The viscosity is also controlled by adjusting the volume fraction of the filler powder in the paste. When the filler weight percent is low, for example, 30 % in weight, a solvent drying process, for example, 100°C, 1 hour, is required to adjust the viscosity of the paste before dispensing the paste on to a desired foot print.

In order to characterize the electrical and mechanical properties, joined samples made of the tin-plated copper-filled conductive paste are manufactured by laminating two "L-shaped" copper coupons. The lamination is performed at a temperature slightly above the melting point of Sn, for example, 250°C, at a pressure of 25 psi. In order to compare the conductivity values, other joined samples are also fabricated under the similar process by using commercial Ag-epoxy and Sn/Pb eutectic solder paste materials. The joined samples made of the paste according to the present invention showed the lowest electrical resistance value; for example, 2.6x10⁻⁵ ohm for Sn-plated Cu paste, 4.7x10⁻⁵ ohm for Sn/Pb solder paste, and 7.3x10⁻⁵ ohm for Ag-epoxy for a contact area of about 0.050 inch by 0.050 inch. The resistance of the paste according to the present invention, is even lower than that of the Sn/Pb solder paste. This can be attributed to the difference in the bulk conductivities of copper versus Sn/Pb solder.

Measurements of the joint strength has also demonstrated that the joint made using the paste according to the present invention has a higher joint strength than that made of the Ag-epoxy paste.

The ECP made of Sn-plated Cu powder and polyimide-siloxane resin is a good candidate for the high temperature solder joints such as C4 and solder ball connection (SBC) to a ceramic substrate. However, for the polymeric printed circuit board applications, this ECP is not adequate, because the reflow temperature such as 250°C is much higher than the glass transition temperature of the polymeric resin, for example, FR-4. A candidate for this purpose is an ECP made of Indium-plated Cu powder formulated with polyimide-siloxane resin. The reflow temperature of the Indium-plated Cu powder paste is about 180°C, which is even lower than the reflow temperature of the Pb/Sn eutectic solder, 215°C. Referring to FIG. 4, the paste is disposed between surface 40 and 42 and heated to the reflow temperature, which causes the conductive coating 34 of a particle 32 to fuse to the conductive coating 34 of an adjacent particle to form a bond 44 therebetween. Additionally, metallurgical bonds 46 are also formed between the contact surfaces 42 and the particles adjacent to these surfaces.

In light of the environmental issues, alternative polymer resins made from renewable or bio-based systems such as functionalized lignin, cellulose and wood or crop oils can be also used. These resins are biodegradable or made from non-fossil fuel resources and allow ease of recycling when the electronic assemblies are dismantled at the end of their useful life.

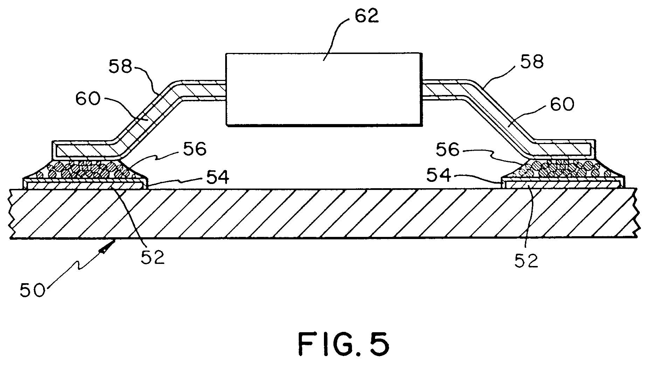

FIG. 5 depicts schematically an IC package attached to a PCB 50 by using a conductive paste according to the present invention. The conductive paste is screen printed on to each copper bond pad 52 on a PCB as practiced with the conventional solder paste. Pad 52 typically has a Sn coating 54. The paste 56 is disposed between Sn 58 coated lead frame 60 which electrically interconnects SMT plastic package 62 to PCB 50. The fine-pitch SMT assembly typically uses a pad spacing of about 0.025" or less. Therefore, the particle size of the tin-coated powder should be in the range of 5 to 10 µm . The joining operation is combined with the polymer curing process at the temperature between 120 and 150°C. This low temperature process would introduce a much less amount of thermal distortion to the PCB compared to the soldering process. In addition, the joining process is free of external fluxes and no flux cleaning step is required.

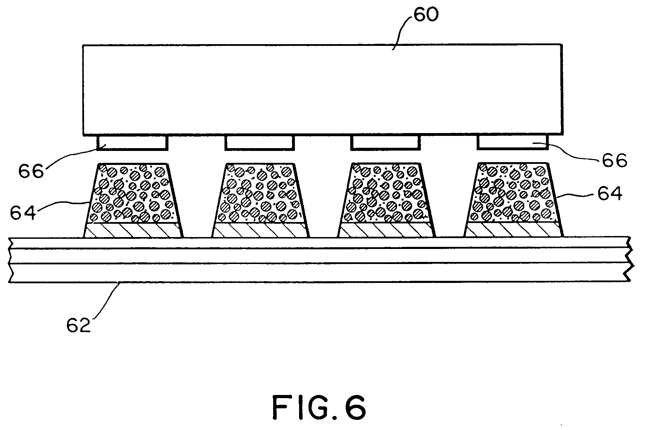

FIG. 6 depicts an IC chip 60 attached to a high-density circuit card 52 such as surface laminated circuits (SLC), where the conductive paste material 64, according to the present invention, is dispensed in a two-dimensional array matching the footprint of the chip pads 66. The joining metallurgy on the chip side is preferably Cr/Cu/Au, and Au-to-Sn bond is expected to form at this interface. Since polyimide siloxane is a thermoplastic copolymer, this joint can be reworked by heating to about 200°C in the presence of NMP as a solvent. In case of direct chip attachment using C4 solder bumps, an encapsulation process is employed to obtain a desired thermal fatigue resistance of the solder joints. In the present application, the polymer matrix serves as a flexible phase that allows accommodation of the thermal mismatch strains between the substrate and the components. Additionally, one can encapsulate the spaces between the paste pads with a second polymer to further enhance the thermal fatigue resistance if desired.

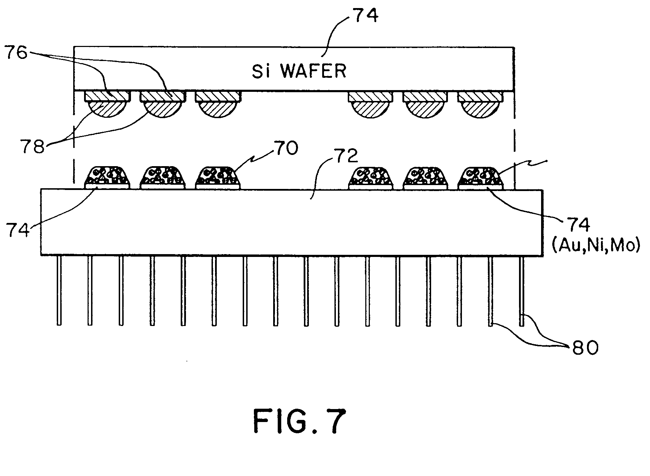

FIG. 7 shows an application for wafer-scale burn-in of C4 chips. The conductive paste material 70 is dispensed on a multilayer ceramic substrate 72 whose pad footprint 74 is matched with the silicon wafer pad footprint 76 on which are disposed C4 solder mounds 78 to be tested and burnt-in. The MLC substrate provides interconnects required to power the chips up during burn-in and the external I/O through a pin grid array 80. The conductive paste on the substrate is cured and the Sn-coated particles are bonded together with the C4's on the wafers before the burn-in step. The burn-in operation is performed typically at 150 C, 6 hr. After burn-in, the substrate is separated from the wafer, and can be used again by etching away any residual solder transferred from the C4 bumps during the test, or by dissolving the pads in NMP and re-screening the paste to form new pads. The chip C4 pads themselves would not have changed shape or composition due to the limited metallurgical contact area and pressure between the paste and the solder. Thus one should be able to clean the good chips in a suitable solvent (such as NMP) and assemble them on substrates as per normal process without any problems or added reflow steps.

Examples of new electrically conductive paste materials according to the present invention to be used for the applications of surface mount package assembly to a printed circuit board, direct chip attachment to a fine-pitch card, and wafer-scale burn-in of flip chips, in several types of formulations are as follows:
- copper powder coated with a thin layer of low melting point, non-toxic metals, such as Sn, In, Bi, Sb, and their alloys, mixed with an environmentally-safe fluxing agent, such as no-clean or water-soluble flux.
- tin-coated copper powder, mixed with polyimide siloxane, NMP solvent, and butyric acid and ethylene glycol or no-clean flux.
- tin-coated copper powder, mixed with renewable or bio-based polymer resin, suitable solvent, and butyric acid and ethylene glycol or no-clean flux.
- indium-coated copper powder, mixed with polyimide siloxane, NMP solvent, and butyric acid and ethylene glycol or no-clean flux.
- indium-coated copper powder, mixed with renewable or bio-based polymer resin, suitable solvent, and butyric acid and ethylene glycol or no-clean flux.
- an optimized formulation for the surface mount application, comprising indium-coated copper powder of 30 to 90 % in weight, polyimide siloxane, NMP solvent, and butyric acid and ethylene glycol or no-clean flux.
- an optimized formulation for the direct chip attach application, comprising indium-coated copper powder of 30 to 90 % in weight, polyimide siloxane, NMP solvent, and butyric acid and ethylene glycol or no-clean flux.
- an optimized formulation for the burn-in application, comprising tin-coated copper powder of 30 to 90 % in weight, polyimide siloxane, NMP solvent, and butyric acid and ethylene glycol or no-clean flux.

The conductive pastes according to the present invention can be used as conducting lines, ground planes, and via fills in the conventional printed circuit boards by replacing either the additive or subtractive Cu technology. This will facilitate the elimination of process steps and chemicals thus reducing cost and the environmental impact associated with printed circuit board manufacturing.

While the present invention has been described with respect to preferred embodiments, numerous modifications, changes, and improvements will occur to those skilled in the art without departing from the spirit and scope of the invention.

## Claims

1. A structure (30) comprising:
a plurality of particles (34);
each of said plurality of particles has an electrically conductive coating (32);
at least some of said particles are fused to other said particles through said electrically conductive coating.

2. A structure according to claim 1, wherein said plurality of particles are embedded within a polymeric material (36).

3. A structure according to claim 1, wherein said structure is an electrical interconnection means.

4. A structure according to any one of claims 1 to 3, wherein said electrically conductive coating has a melting temperature less than that of said particle.

5. A structure according to claim 1, further including a first and a second surface between which said structure is disposed to provide interconnection between said first and second surfaces.

6. A structure according to claim 2, wherein said polymeric material is a cured or uncured thermoplastic adhesive.

7. A structure according to claim 1, wherein said particles are formed from a material selected from the group consisting of Cu, Au, Ag, Al, Pd and Pt.

8. A structure according to claim 1, wherein said coating is selected from the group consisting of Sn, Zn, In, Pb, Bi and Sb.

9. A structure according to claim 1, wherein said polymeric material is selected from the group consisting of polyimide, siloxane, polyimide siloxane, and bio-based polymeric resins derived from lignin, cellulose, wood oil and crop oil.

10. A structure according to claim 5, wherein said first electrically conductive surface is a first electronic device contact location and wherein said second electrically conductive surface is a second electronic device contact location.

11. A structure according to claim 10, wherein said first electronic device is a semiconductor chip and said second electronic device is a packaging substrate.

12. A structure according to claim 5, wherein one of said first and said second electrically conducting surfaces is a solder surface.

13. A structure according to claim 1, wherein said structure is an electronic device, preferably a computing device.

14. A method comprising the steps of:
providing a paste of a structure according to any one of claims 1 to 9;
disposing said paste between a first and second electrically conductive surface;
heating said paste to a first temperature sufficient to fuse said coating on adjacent particles to form a network of interconnected particles with spaces there between;
heating said paste to a second temperature sufficient to cure said polymer in said spaces.

15. A method according to claim 14, wherein said first electrically conductive surface is a chip pad and said second electrically conductive surface is on a substrate, further including:
heating and applying electrical power to burn-in said chip;
separating said chip from said substrate.

16. A structure comprising:
particles of copper having a coating selected from the group consisting of Sn and In;
said particles are contained within a thermoplastic polymer precursor and a solvent.

17. A structure according to claim 1, wherein said particles are from about 30% to about 90% by weight of said structure.

18. A method according to claim 14, further including pressing said first surface towards said second surface.

19. A method according to any one of claims 14 to 16 and 18, wherein said first temperature and said second temperature are from about 150°C to about 250°C.

20. A method according to any one of claims 14 to 16 and 18 to 19, where in said step of separating is done by heating in the presence of a solvent.

21. A structure comprising:
copper powder coating with a layer of a material selected from the group consisting of Sn, In, Bi, Sb and combinations thereof mixed with a fluxing agent.

22. A structure according to claim 21, further including NMP solvent, butyric acid and ethylene glycol and a material selected from the group consisting of polyimide, siloxane, polyimide siloxane and a bio-based polymer resin.

23. A structure according to claim 21, wherein said copper powder is from about 30% to about 90% by weight of said structure.

24. A structure according to claim 1, wherein said particles form a metallurgical bond to said first and said second surfaces.

25. A structure according to claim 5, wherein siad first and said second surfaces are electrically conducting.
